Europäisches Patentamt

European Patent Office

Office européen des brevets

(19)

(11) Veröffentlichungsnummer: **0 252 882 B1**

(12) **EUROPÄISCHE PATENTSCHRIFT**

(45) Veröffentlichungstag der Patentschrift: **19.02.92**

(21) Anmeldenummer: **87810382.9**

(22) Anmeldetag: **02.07.87**

(51) Int. Cl.⁵: **B65G 47/57**, B65G 65/00, H05K 13/00, F26B 15/20, B65G 17/12, B65G 47/84

(54) **Fluchtungs- und Zentriereinrichtung für die Arme gabelförmiger Plattenträger beim Ein- und Entladen der Platten.**

(30) Priorität: **08.07.86 CH 2752/86**

(43) Veröffentlichungstag der Anmeldung:
**13.01.88 Patentblatt 88/02**

(45) Bekanntmachung des Hinweises auf die Patenterteilung:
**19.02.92 Patentblatt 92/08**

(84) Benannte Vertragsstaaten:
**AT BE CH DE FR GB IT LI NL SE**

(56) Entgegenhaltungen:
**DE-C- 1 273 414**
**US-A- 1 736 866**

(73) Patentinhaber: **CIBA-GEIGY AG**
**Klybeckstrasse 141**
**CH-4002 Basel(CH)**

(72) Erfinder: **Wenger, Hartmut**
**St.Jakobstrasse 81**
**CH-4133 Pratteln(CH)**

## Beschreibung

Die Erfindung betrifft eine Fluchtungs- und Zentriereinrichtung gemäß dem Oberbegriff des Patentanspruchs 1.

Bei der Herstellung von beschichteten Platten wie Druckgutplatten und insbesondere von gedruckten elektrischen und elektronischen Leiterplatten besteht ein wachsendes Bedürfnis nach weitgehender Automatisierung nicht nur aller Behandlungsschritte, sondern der gesamten Anlage, um die Herstellungskosten aus Wettbewerbsgründen zu senken. Es genügt daher nicht nur, einzelne Herstellungsschritte voll zu automatisieren, sondern eine vollständige Automatisierung muß auch den Transport der Fabrikate zwischen den verschiedenen Behandlungsstationen einschließen.

Unter den verschiedenen bekannten Transportsystemen haben sich besonders diejenigen durchgesetzt, die gabelförmige Plattenträger von allgemein U-förmiger Gestalt aufweisen. Diese Träger sind an einem geeigneten, sich auf Strecken des Förderweges aufwärts- und/oder abwärtsbewegenden Antriebsmechanismus fest montiert, der intermittierend mit Unterbrechungen für das Ein- und Entladen der Platten angetrieben wird.

Das rückwärtige Ende eines jeden gabelförmigen Plattenträgers wird dabei über ein Querglied am Antriebsmechanismus, z.B. an den Kettengliedern starr befestigt und ist in einer senkrecht zur Antriebsrichtung der beiden Transportketten, z.B. in den geradlinigen Förderstrecken horizontal, ausgerichtet, während das andere, von zwei parallelen Gabelarmen gebildete offene Trägerende mindestens angenähert in der gleichen Ebene liegen soll. Der Antriebsmechanismus kann einen einzigen oder vorzugsweise mehrere solcher gabelförmigen Plattenträger aufweisen.

In der US-A-1 736 866 wird ein Trocknungsapparat für feuchte Platten beschrieben, der einen aufsteigenden Bereich umfaßt, durch welchen zwei über obere und untere Zahnräder umgelenkte Transportketten laufen, an denen gabelförmige Plattenträger des oben beschrieben Typs mit ihren geschlossenen Trägerenden befestigt sind. An einem Maschinengestell ist auf einer bestimmten Ebene nahe dem unteren Ende des aufsteigenden Transportbereichs eine Ladeeinrichtung neben den freien Gabelenden der vorbeilaufenden Plattenträger angeordnet und schiebt eine zu trocknende Platte über ihre Vorderkante auf einen Plattenträger, der während seiner intermittierenden Aufwärtsbewegung etwa auf dem gleichen Niveau wie die in der Beladungseinrichtung befindliche Platte angehalten hat.

Diese bekannte Vorrichtung umfaßt am oberen Ende des aufsteigenden Bereichs des Antriebsmechanismus eine Transfereinrichtung, die die Platte horizontal vom aufsteigenden Bereich zu einem Plattenträger am oberen Ende des absteigenden Bereichs paternosterartig verschiebt. Am Fußende des absteigenden Bereichs des Transportmechanismus ist eine entsprechende Plattenentladeeinrichtung vorgesehen.

Ähnliche Anlagen sind in den US-A-3 378 131 und US-A-4 058 908 beschrieben.

In diesen bekannten Anlagen wird eine zu trocknende Platte am oberen Ende der Geradführungsstrecken des Transportmechanismus also paternosterartig vom aufsteigenden auf den absteigenden Bereich verschoben, wodurch die Platten den absteigenden Bereich mit der gleichen Plattenfläche nach oben weisend durchlaufen, wie den aufsteigenden Bereich. Dies ist zulässig, wenn nur eine Plattenfläche teilweise beschichtet bzw. bedruckt werden soll. Jedoch ist es insbesondere bei der Herstellung elektronischer Leiterplatten, aber auch bei anderen Anwendungsgebieten erforderlich, beide Seiten der z.B. aus Papier, Karton, Kunststoffolie, Holz, Metallblech oder einem anderen für ein besonderes Anwendungsgebiet geeigneten Material hergestellten Platte zu beschichten oder zu bedrucken.

In diesem Falle ist es erwünscht, die Platten zusammen mit ihren jeweiligen Trägern um die Transportzahnräder oder -trommeln am oberen Ende des aufsteigenden Bereichs so herumzuführen, daß die im aufsteigenden Bereich getrocknete Oberseite der Platte im absteigenden Bereich zur Unterseite wird. Nach dem Verlassen einer ersten Trocknungsstation wird die frühere, noch unbedruckte Unterseite der Platte nun deren Oberseite und kann so in einer weiteren Beschichtungsstation beschichtet oder bedruckt werden, worauf sie durch eine weitere Trocknungsstation der oben beschriebenen Art passiert, um schließlich als beidseitig beschichtete und getrocknete Platte aus der zweiten Trocknungsstation ausgegeben zu werden.

In einer Anlage zur Herstellung der letztgenannten Art von Platten dürfen diese also nicht an den oberen Enden der geradlinig auf- bzw. absteigenden Bereiche des Transportmechanismus im wesentlichen horizontal verschoben werden, sondern sie müssen in gleicher Weise umgekehrt werden, wie dies mit den Plattenträgern ohnehin stets geschieht. Hierzu waren vor allem die vorgehend beschriebenen bekannten Plattenträger nicht geeignet, da die Platten auf diese Träger nur lose aufgelegt werden können. Daher wurden bereits Plattenträger vorgesehen, deren beide Gabelarme in ihren einander zugekehrten inneren Seitenwänden Längsnuten enthalten, die an den freien Enden der beiden Gabelarme nach vorne offen sind; hierdurch kann eine im Träger zu sichernde Platte von den vorderen freien Enden der beiden Gabelarme her in die Nuten eingeschoben werden; dabei können diese Enden seitlich nach auswärts abgebogen sein, um das Einschieben der Vorderkante einer Platte in die offenen Nutenden zu erleichtern. Die sich mit den beiden Gabelarmen parallel erstreckenden Plattenränder werden in den Längsnuten der Gabelarme auch beim Umkehren des Trägers festgehalten und dürfen selber natürlich nicht beschichtet oder bedruckt sein, da sie sonst im Plattenträger beim Trocknen festkleben und das Entladen der Platte erschweren oder verhindern würden.

Derart in die Plattenträger eingeschobene Platten werden wie gesagt zusammen mit ihren Trägern am oberen Ende des Transportweges umgeklappt. Jedoch ergab sich hieraus eine unvermeidliche, nur schwer zu erfüllende Forderung, daß die freien Gabelarmenden genau gegenüber der Vorderkante der in die Längsnuten der Gabelarme einzuführenden Platten angehalten werden müssen und daß weiterhin die Gabelarme in ihrer gesamten Länge mit der Gesamtlänge der Platte einwandfrei oder mindestens nahezu einwandfrei, praktisch in der gleichen Ebene miteinander fluchten sollen, da andernfalls die Gefahr besteht, daß die gegenüberliegenden Ränder der Platte sich in den Gabelarmnuten verklemmen, so daß die vielleicht erst teilweise, z.B. nur zur Hälfte eingeführte Platte im Träger feststecken würde.

Diese absolute Forderung ist in der Praxis bisher nicht zufriedenstellend erfüllt worden, und zwar aus verschiedenen Gründen, von denen einer darin liegt, daß beim Betrieb unregelmäßig verschieden viele Platten, falls sich die Trocknungskammer in Bezug auf die Platteneinführungsebene nach oben erstreckt, in eine entsprechende Anzahl Träger des aufsteigenden Transportbereichs eingeladen werden. Erstreckt sie sich hingegen nach unten, so wird entsprechend der absteigende Bereich mit einer von Zeit zu Zeit unterschiedlichen Anzahl Platten beladen. Als Folge der ständig wechselnden Belastung des aufsteigenden bzw. des absteigenden Bereichs weisen die Transportkettenglieder in kurzer Zeit verschieden großes Spiel auf. Hierdurch können die Gabelarme der Plattenträger nicht mehr mit der erforderlichen Genauigkeit horizontal ausgerichtet gehalten werden. Weiter können ihre Gabelarme sich infolge klimatischer oder anderer äußerer Einflüsse in Bezug auf die geschlossenen Anschlußstücke der Träger, über die sie mit dem Transportmechanismus fest verbunden sind, verwerfen bzw. verbiegen.

Aus diesem Grunde wurde bereits eine Versuchsanlage mit einer Zentriereinrichtung konstruiert, die an den beiden Gabelarmen des Trägers bei dessen Anhalten beim Beladen ausrichtend eingreifen sollte. Bei diesem Stand der Technik, der dem Oberbegriff des Anspruchs 1 entspricht, bestand die Zentriereinrichtung aus je einem Zapfen auf jeder der voneinander abgewandten Außenseiten der beiden Gabelarme, und zwar in einem mittleren Bereich derselben zwischen deren hinterem, befestigtem und dem vorderen, freien Gabelarmende, sowie einem mit diesem Zapfen zusammenwirkenden Zentrierglied, das eine Nut aufwies, die sich am einen Ende des Zentriergliedes nach vorwärts oder rückwärts nach außen zu mit V-förmigem Querschnitt erweiterte, je nach der Stelle, an welcher die beiden Gabelarme die aus ihnen hervorstehenden Zapfen trugen. Zwei solche Glieder der Zentriereinrichtung waren im Maschinenrahmen, das eine auf der rechten und das andere auf der linken Seite der beiden Gabelarme eines in der betreffenden Station anhaltenden Trägers, stationär angeordnet, konnten aber parallel zur Platteneinführungsebene, in der sich die Gabelarme im Idealfall erstrecken sollten, verschoben werden und sollten hierdurch mit den Einzelzapfen auf den Außenseiten der Gabelarme in Eingriff gebracht werden.

Leider ergab sich, daß der Öffnungsbereich der zum Erfassen eines auf einem schlecht mit der letztgenannten Ebene fluchtenden Gabelarm über oder unterhalb der genannten Ebene gelegenen Zentriernockens vorgesehenen, sich zum Nocken hin erweiternden Nutenmündung des Zentriergliedes nicht weit genug war, um den Nocken auf dem einen Gabelarm, oder auch die Nocken auf den Außenseiten beider Gabelarme mit Sicherheit zu erfassen. Der Erfassungsbereich einer solchen Nutenmündung des Zentriergliedes kann nämlich nicht beliebig vergrößert werden, da es sonst vorkommt, daß der Nocken eines Gabelarmes des dicht darunter oder darüber liegenden Plattenträgers erfaßt wird; denn die Abstände zwischen den Plattenträgern in ihrer Anordnung dicht übereinander, in der sie den geradlinigen auf- oder absteigenden Bereich des Transportweges durchlaufen sollen, muß klein gehalten werden, wenn die Durchsatzrate der Anlage wirtschaftlich bleiben soll.

Auch kam es immer wieder vor, daß das Zentrierglied mit einem außerhalb der Nutenmündung gelegenen Bereich seiner Stirnseite gegen den Nocken des Gabelarmes, den es eigentlich erfassen sollte, anstieß, statt daß der Nocken in die Mündung eintrat und in seine gewünschte Stellung in der Zentriergliednut hineinglitt; durch das Anstoßen wurde vielmehr der Gabelarm verbogen und damit noch größere Abweichungen von der Sollstellung und sogar Beschädigungen des Mechanismus verursacht. War der Fluchtungsfehler zwischen den Gabelarmen eines Plattenträgers und der Platteneinführungsebene noch größer, so konnte es geschehen, daß die Nocken auf den beiden Gabelarmen von den Zentriergliedern vollständig verfehlt wurden und die vorgeschobene, zu trocknende Platte über oder unter den Plattenträger zu liegen kam, in dessen Gabelarmnuten sie hätte eingeschoben werden sollen. Der gesamte Plattentransport konnte hierdurch ernstlich gestört und mußte dann unterbrochen werden. Plattenträger mit verbogenen Gabelarmen können also nicht nur ein Verklemmen der zu trocknenden Platte im Träger verursachen und beim Beladen und Entladen einen nicht überwindbaren Widerstand bieten, sondern bei sehr starker Deformierung des einen oder beider Gabelarme kann es auch vorkommen, daß selbst beim erfolgreichen Erfassen der Zentriernocken durch die Zentrierglieder der Versuchskonstruktion die auf die freien Gabelenden zu bewegte Platte gleichwohl die Eingangsöffnungen in die Gabelarmnuten völlig verfehlt.

Eine unvermeidbare Folge dieser Auswirkungen ist dann eine Unterbrechung des Betriebes der gesamten Anlage, die nur noch Plattenausschuß liefert. Stark deformierte Träger müssen natürlich laufend ausgetauscht werden.

Als weiteres Problem wurde beobachtet, daß Plattenträger durch äußere Einflüsse wie z.B. starke Temperaturschwankungen, denen sie während des Transportvorganges, wie es bei Kühl-, Aufheiz- oder Einbrennstationen der Fall ist, ausgesetzt sind, erhebliche Dimensionsänderungen besonders an Löt- oder Schweißstellen ihres Zusammenbaus erleiden, die zu einem starken Verwerfen oder Verziehen insbesondere der Gabelarme des Plattenträgers führen.

Die Erfindung löst nun die Aufgabe, eine Fluchtungs- und Zentriereinrichtung für gabelförmige Plattenträger vor allem an einer Plattenbeladestation, gegebenenfalls aber auch an einer Plattenentladestation zu schaffen, die von den vorgehend beschriebenen Nachteilen frei ist und die geeignet ist, die beiden hinteren Gabelarmenden des Plattenträgers genau auf die Platteneinführungsebene auszurichten, und anschließend die freien Gabelenden so zu zentrieren, daß sie genau mit der vorlaufenden Kante der herangeführten Platte fluchten, um so ein ungehindertes, glattes Einführen der Platte in die Gabelarmnuten zu gewährleisten, auch wenn einer oder beide Gabelarme beträchtlich verworfen oder verbogen sein sollten.

Die Erfindung löst diese Aufgabe, indem der Zentriervorgang in eine Vorzentrierung durch Ausrichten des mittleren und rückwärtigen Bereichs der Plattenträgerarme auf die Platteneinführungsebene einer Beladungsstation und eine direkt anschließende Feinzentrierung, in der die vorderen Gabelarmenden ebenfalls genau auf diese Ebene ausgerichtet bzw. auf die vordere Plattenkante der herangeführten Platte zentriert werden, aufgeteilt wird. Dies geschieht durch die im kennzeichnenden Teil des Anspruchs 1 aufgeführten Merkmale.

Bevorzugte Ausführungsformen der Fluchtungs- und Zentriereinrichtung nach der Erfindung weisen mindestens eines der in den Unteransprüchen beschriebenen Merkmale auf.

Weitere Einzelheiten der Fluchtungs- und Zentriereinrichtung nach der Erfindung ergeben sich aus der folgenden Beschreibung einer bevorzugten Ausführungsform derselben im Zusammenhang mit den beigefügten Zeichnungen; in diesen zeigen:

Fig. 1 eine schematische Darstellung der Seitenansicht einer zwei Beschichtungs- oder Bedruckungsstationen und zwei mit Fluchtungs- und Zentriereinrichtungen nach der Erfindung ausgerüstete Trocknungsstationen umfassenden Anlage;

Fig. 1A eine schematische Draufsicht auf einen eine solche Trocknungsstation umfassenden Abschnitt der in Fig. 1 gezeigten Anlage;

Fig. 2 eine Draufsicht auf einen gabelförmigen Plattenträger zusammen mit einer bevorzugten Ausführungsform der Fluchtungs- und Zentriereinrichtung nach der Erfindung in deren Ausgangsstellung;

Fig. 2A eine Seitenansicht der gleichen Teile wie in Fig. 2, in Richtung der Pfeile IIA gesehen und teilweise im Längsschnitt in einer durch IIA-IIA in Fig. 2 angedeuteten Ebene:

Fig. 3 eine Draufsicht der gleichen Teile wie in Fig. 2, aber in einer Zwischenstellung beim Einfluchten;

Fig. 3A eine Seitenansicht der gleichen Teile wie in Fig. 2A, aber in der gleichen Stellung wie in Fig. 3, in Richtung der Pfeile IIIA gesehen und teilweise längs der in Fig. 3 durch IIIA-IIIA angedeuteten Ebene geschnitten;

Fig. 4 eine Draufsicht auf die gleichen Teile wie in Figuren 2 und 3, aber in der Endstellung, in welcher eine Platte in die vollständig eingefluchteten und zentrierten Gabelarme des Trägers eingeführt ist;

Fig. 4A eine Seitenansicht der gleichen Teile wie in Figuren 2A und 3A, aber in der in Fig. 4 gezeigten Stellung, in der in Fig. 4 durch Pfeile IVA angedeuteten Richtung gesehen;

Fig. 5 einen Querschnitt durch ein rückwärtiges Zentrierglied der gezeigten Ausführungsform in einer in Fig. 4 durch V-V angedeuteten Ebene;

Fig. 6 eine Ansicht, teilweise im Querschnitt, durch den linksseitigen, in Fig. 4 gezeigten Gabelarm und benachbarte Teile, entlang einer in Fig. 4 durch VI-VI angedeuteten Ebene; und

Fig. 7 eine Vorderansicht eines vorderen Zentriergliedes der in Fig. 4 gezeigten Ausführungsform, gesehen in der in Fig. 4 durch Pfeile VII angedeuteten Richtung.

Die Gabelarme werden je nach ihrer Lage bei Blick vom rückwärtigen Querstück zu den vorderen, freien Gabelarmenden des Plattenträgers hin als "links" bzw. "rechts" gelegen bezeichnet.

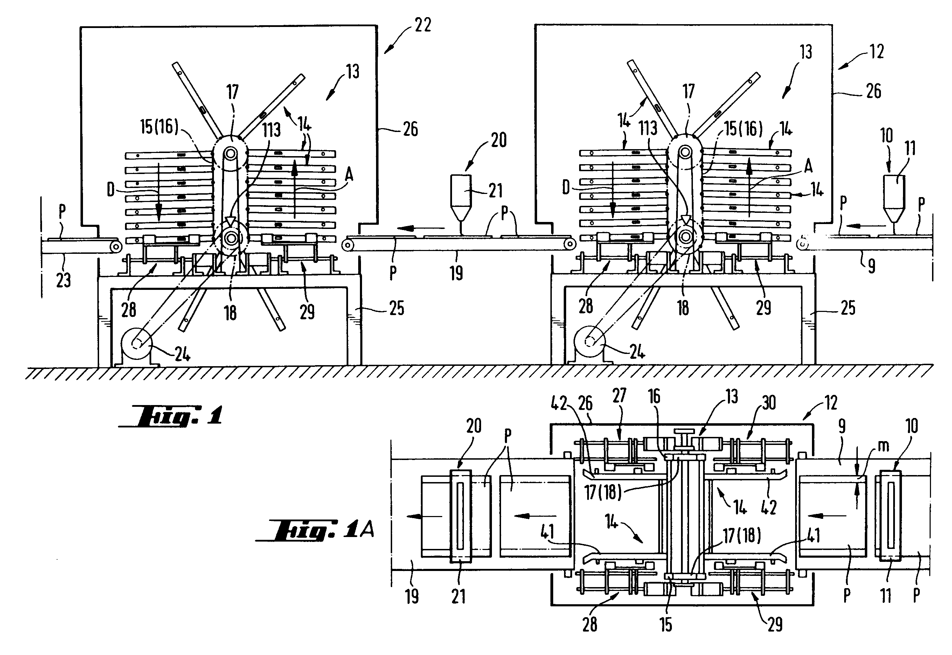

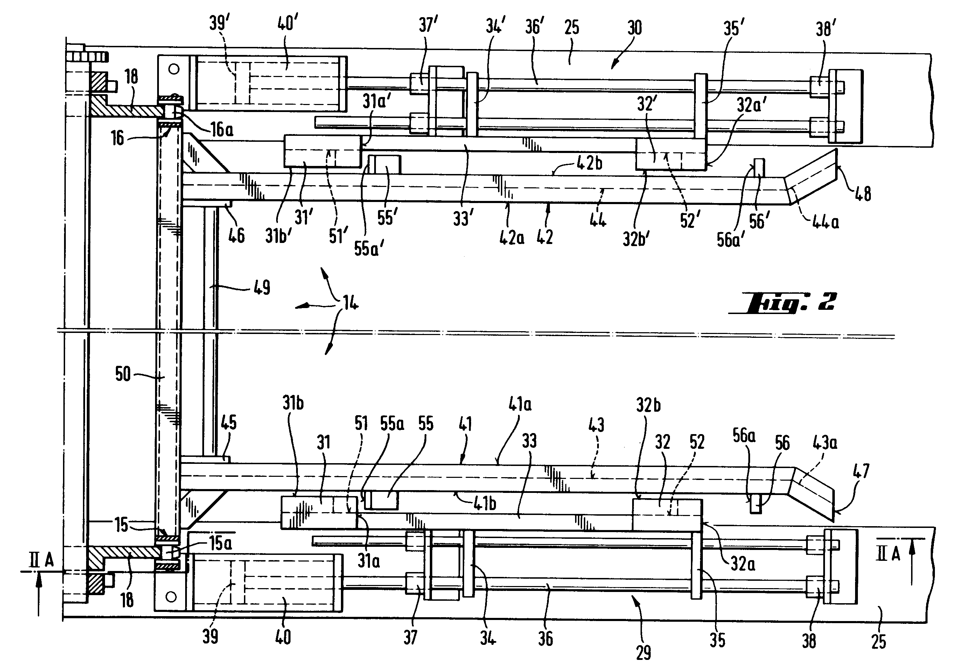

In Fig. 1 ist schematisch eine Plattenbehandlungsanlage gezeigt, die eine erste Beschichtungsstation 10, in welcher die Oberseite der auf einem Transportband 9 vorbeibewegten Platten P mit Hilfe eines üblichen Gießkopfes 11 beschichtet wird. Die einseitig beschichteten Platten werden dann zu einer ersten Trocknungsstation 12 befördert, in welcher ein mit Platten haltenden Trägern 14 ausgerüsteter Transportmechanismus 13 die Platten P mit ihrer beschichteten Seite nach oben von der Beschichtungsstation 10 empfängt.

Aus Fig. 1A ist zu ersehen daß die Längsränder m der Platten P unbeschichtet bleiben. Die Beschichtungen können natürlich kontinuierlich oder diskontinuierlich erfolgen, z.B. durch Bedrukken. Die Beschichtungen können alphanumerisch sein oder in Gestalt von Leitungen einer elektronischen Schaltung erfolgen, oder jede andere beliebige Konfiguration je nach ihrer Verwendung aufweisen. Der Transportmechanismus 13 umfaßt zwei Transportketten 15 und 16, die um Umlenkzahnrollen 17 und 18 am oberen und unteren Ende des Förderweges geführt werden und trägt die Platten P, die in gesicherter Stellung in ihren Trägern 14 gehaltert sind, aufwärts durch eine ansteigende Strecke A des Förderweges, kehrt dann die Platten am oberen Ende des Förderweges um und trägt sie mit ihrer früheren Unterseite nunmehr oben abwärts durch eine absteigende Strecke D, an deren Fußenden die Platten P aus den Plattenträgern 14 herausgezogen bzw. durch bekannte Mittel (nicht gezeigt) herausgestoßen und auf ein Förderband 19 mit ihrer getrockneten ursprünglichen Oberseite als Unterseite und mit ihrer noch unbedruckten Seite als Oberseite gebracht werden.

Hierauf bringt das Förderband 19 die Platten P an einer zweiten Beschichtungs- oder Bedruckungsstation 20 vorbei, in welcher die nunmehrigen Oberseiten der Platten P mit Hilfe eines weiteren Gießkopfes 21 beschichtet bzw. bedruckt werden, worauf die Platten in eine zweite Trocknungsstation 22 gelangen, welche den gleichen Fördermechanismus wie die Trocknungsstation 12 aufweist.

Schließlich werden die Platten, deren beide Seiten beschichtet oder bedruckt und getrocknet sind, aus der Anlage auf ein weiteres Förderband 23 gegeben, das die trockenen Platten einer weiteren Station der Anlage zuführt.

Jede Trocknungsstation 12,22 umfaßt einen Antriebsmotor 24, einen Maschinenrahmen 25, ein Gehäuse 26 und Fluchtungs- und Zentriereinrichtungen 27-30 nach der Erfindung.

Um die Platten P in den Transportmechanismus 13 ein- und aus diesem wieder ausladen zu können, müssen die Förderketten 15,16 stets während einer kurzen Pause angehalten und dann längs des Förderweges weiterbewegt werden. Diese unterbrochene Bewegung wird durch eine elektronische Steuereinheit geregelt, von der nur ein Fühler, z.B. eine photoelektrische Zelle 113 gezeigt ist. Die Fluchtungs- und Zentriereinrichtungen 27 und 28 können dann weggelassen werden, wenn die Überführung der auf der einen oder beiden Seiten getrockneten Platten auf das Förderband 19 bzw. 23 bequem dadurch erfolgen kann, daß die Plattenträger 14, aus denen die Platten am Fußende der absteigenden Strecke D entladen werden sollen, während der Entladepause auf einem Niveau geringfügig oberhalb der Förderbänder 19 bzw. 23 angehalten werden können.

Doch kann es aus den weiter oben angeführten Gründen vorteilhaft sein, Fluchtungs- und Zentriereinrichtungen nach der Erfindung nicht nur am Fußende der aufsteigenden Strecke A, sondern auch der absteigenden Strecke D vorzusehen, zumindest im Falle der Trocknungsstation 12.

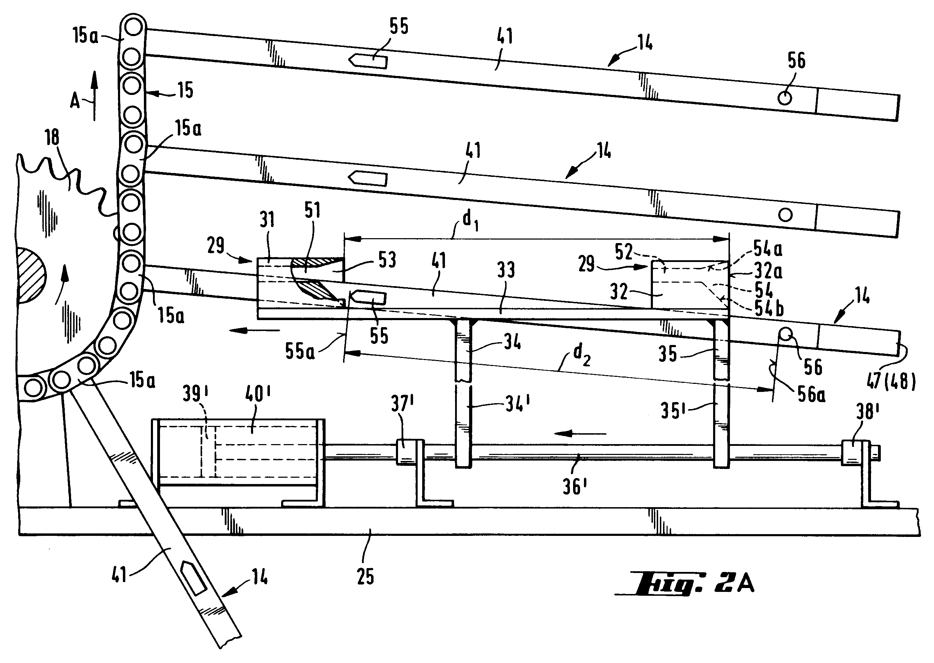

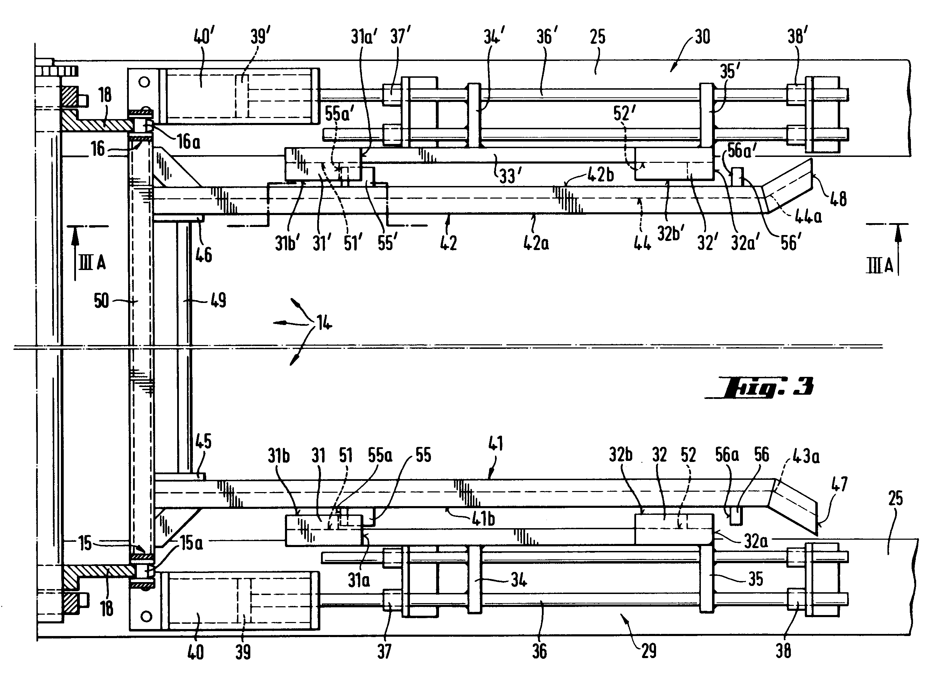

In den Figuren 2 bis 4A sind ein gabelförmiger Plattenträger 14 und, auf dem Maschinenrahmen 25 montiert, eine rechts neben dem (zum offenen Gabelende hinblickend) rechten Trägergabelarm 41 angeordnete Fluchtungs- und Zentriereinrichtung 29 sowie links neben den linken Gabelarm 42 eine linke Fluchtungs- und Zentriereinrichtung 30 dargestellt.

Die beiden Gabelarme 41 und 42 sind starr auf ihrer gemeinsamen Abschlußbarre 50 befestigt, die ihrerseits mit den nebeneinander liegenden Kettengliedern 15a und 16a der Förderketten 15 bzw. 16 fest verbunden ist, und erstrecken sich, während die Kettenglieder, an denen sie befestigt sind, die ansteigende oder absteigende Strecke A bzw. D des Förderweges durchlaufen, im Idealfall horizontal, praktisch jedoch abwärts geneigt und oft gegeneinander verworfen und/oder verbogen.

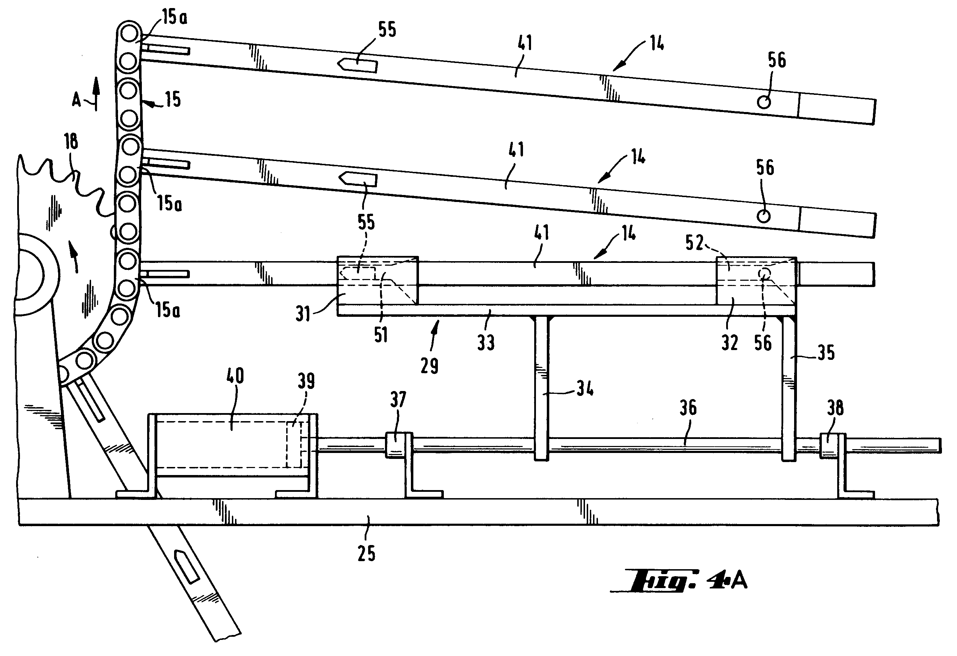

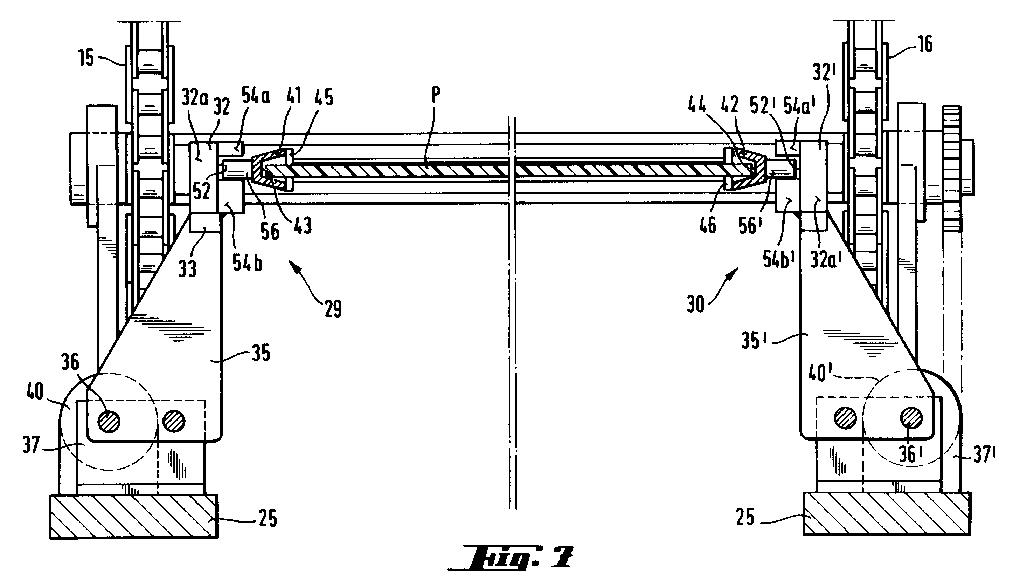

Auf den Innenwänden 41a und 42a der Gabelarme 41 und 42 sind Längsnuten 43 bzw. 44 vorgesehen (siehe auch Fig. 6), welche zur Aufnahme der unbeschichteten Ränder m einer Platte P, z.B. einer elektronischen gedruckten Schaltung bestimmt sind (Fig. 4).

An den rückwärtigen Enden der Gabelarme 41 und 42, mit denen sie an den Abschlußbarren 50 angeschlossen sind, sind Stoppglieder 45 und 46 auf den Gabelarminnenseiten 41a und 42a vorgesehen, die das Eindringen einer in die Längsnuten 43 und 44 des Trägers 14 eingeführten Platte P begrenzen. Die freien Enden 47 und 48 der Gabelarme 41 und 42 sind in Vorwärtsrichtung nach außen abgebogen und die Längsnuten in den Gabelarmen weisen in diesen freien Gabelarmenden nach vorwärts gerichtete Öffnungen 43a, 44a auf.

Ein Querholm 49 ist zwischen den Stoppgliedern 45 und 46 eingebaut und stabilisiert die Stellung der Gabelarme 41 und 42. Auch können die Stoppglieder 45,46 in den Längsnuten 43 und 44 vorwärts- und rückwärts verschieblich eingreifend ausgebildet sein, so daß eine Ausstoßvorrichtung (nicht gezeigt) am Querholm 49 eingreifen und dazu dienen kann, eine getrocknete Platte P durch Vorwärtsbewegen der Stoppglieder 45,46 auszustoßen, um die Stoppfeder anschließend in ihre Ausgangsstellung zurückzuziehen.

Der Aufbau der Fluchtungs- und Zentriermechanismen 27 bis 30 wird nun im einzelnen anhand der besonders in den Figuren 2 und 2A gezeigten Einrichtung 29 erläutert. Die Einrichtung 30 umfaßt die gleichen Teile in Spiegel symmetrischer Anordnung, wobei die Teile die gleichen Bezugszeichen, aber "gestrichen" tragen.

Die Fluchtungs- und Zentriereinrichtung 29, die im einzelnen insbesondere in Figuren 2A und 4A gezeigt ist, umfaßt ein rückwärtiges Zentrierglied 31 und ein vorderes Zentrierglied 32, die beide in festem Abstand zu einander auf dem rückwärtigen bzw. dem vorderen Ende einer starren Verbindungsbarre 33 befestigt sind. Die letztere ist über Verbindungsstäbe oder -streben 34 und 35 mit der in Lagern 37 und 38 sicher geführten Kolbenstange 36 verbunden, die ihrerseits mit einem pneumatisch oder hydraulisch betriebenen, in einem Zylinder 40 untergebrachten Kolben 39 verbunden ist. Der Zylinder 40 und die Kolbenstangenlager 37 und 38 sind auf dem Maschinenrahmen 25 stationär befestigt.

Die Zentrierglieder 31 und 32 sind vorzugsweise auf der Verbindungsbarre 33 montiert, können aber natürlich auf der Barre auch in anderer Weise angeordnet oder miteinander durch andere mechanische Mittel verbunden sein, aber stets so, daß ihre vorderen Enden 31a,32a, einen festen Abstand $d_1$ von einander aufweisen. Jedes der Zentrierglieder 31 und und 32 ist in seiner Seitenwandung 31b,32b, welche zu seinem Gabelarm 41 hinweist, mit einer Zentriernut 51,52 versehen, die eine sich nach vorwärts erweiternde Nutenmündung 53,54 besitzt, welche an den vorderen Enden 31a, 32a des betreffenden Gliedes offen ist. Die Zentriernuten 51 und 52 sind so gestaltet, daß sie die Nocken oder Zapfen 55 und 56 erfassen können, die auf der Außenwand 41b des den Zentriergliedern 31 und 32 benachbarten Gabelarmes 41 feststehend angebracht sind, wobei der Abstand $d_2$ zwischen ihren rückwärtigen Enden 55a und 56a etwas größer ist als der Abstand $d_1$ zwischen den vorderen Enden 31a und 32a der Zentrierglieder 31 und 32. Vorzugsweise weist der rückwärtige Eingriffsnocken 55 die Gestalt eines verlängerten Pflockes auf, während der vordere Nocken 56 als runder Stift ausgestaltet ist.

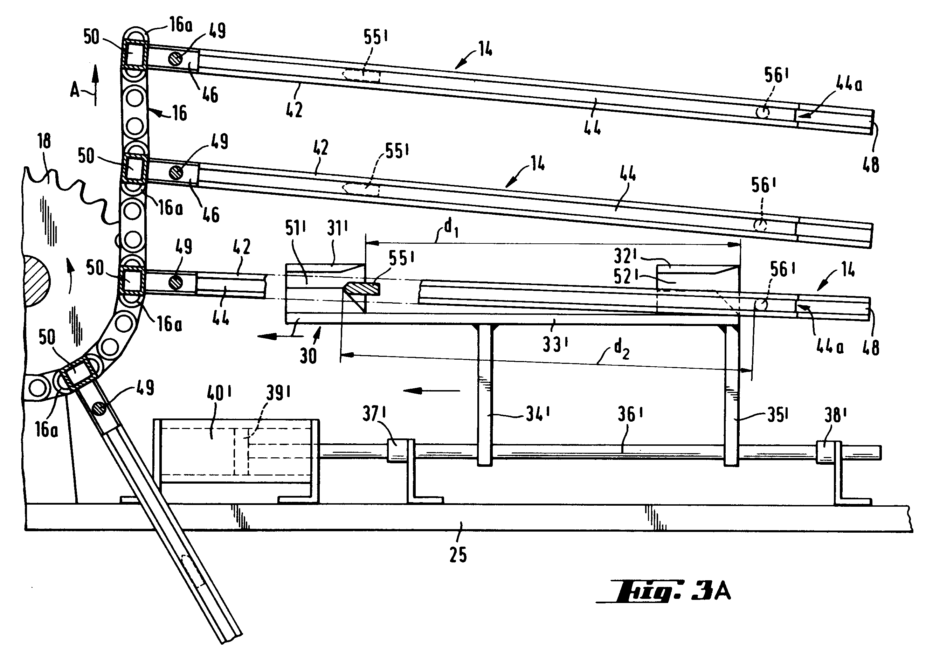

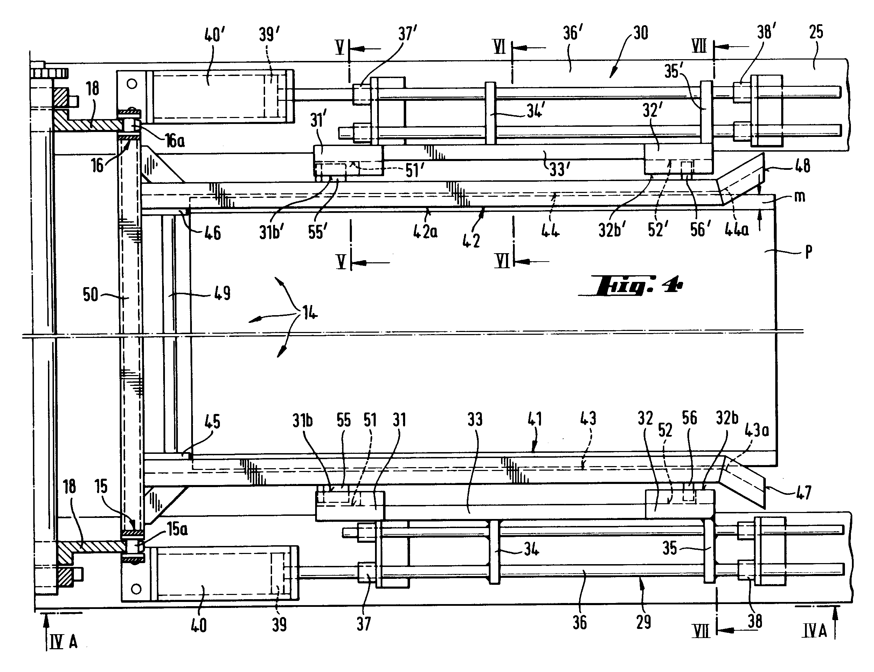

In Fig. 3 und besonders in Fig. 3A sind die entsprechenden Teile der Fluchtungs- und Zentriereinrichtung 30 gezeigt, wobei sie den Teilen in Fig. 2A entsprechen, aber "gestrichen" numeriert.

Trifft ein leerer Plattenträger 14 auf dem Niveau derjenigen Ebene ein, z.B. von oberhalb, in welcher die Platten P durch das Förderband 9 zum Transportmechanismus 13 hinbewegt werden, und hält dort dank der intermittierenden Bewegung des Mechanismus an, so befindet sich der Kolben 39 der Fluchtungs- und Zentriereinrichtung 29 in seiner rückwärtigen Endstellung im Zylinder 40 und auch die Zentrierglieder 31 und 32 befinden sich folglich in ihren rückwärtigen Endstellungen. Das gleiche gilt für den Kolben 39' im Zylinder 40' und für die Zentrierglieder 31' und 32', die zur Fluchtungs- und Zentriereinrichtung 30 gehören.

Die Eingriffsnocken 55 und 56 auf der äußeren Seitenwand 41b des Gabelarmes 41 und die entsprechenden Eingriffsnocken 55' und 56' auf der Außenwand 42b des anderen Gabelarmes 42 halten also vorwärts der vorderen Enden 31a und 32a der Zentrierglieder 31 und 32 der Einrichtung 29 bzw. entsprechend vorwärts den vorderen Enden 31a' und 32a' der Zentrierglieder 31' und 32' der Einrichtung 30 an.

Wie in Fig. 2A ersichtlich, weicht das freie Ende 47 des Gabelarmes 41 erheblich von der horizontalen Stellung ab, die es einnehmen mußte, und das gleiche soll auch für den anderen Gabelarm 42 gelten; der letztere mag mehr oder weniger stark von der horizontalen Ebene abweichen, d.h. der Träger 14 ist recht erheblich verbogen oder "verworfen".

Die Fluchtungs- und Zentriereinrichtungen 29 und 30 werden nun in Betrieb gesetzt und die Kolben 39 und 39' bewegen sich zusammen mit den Verbindungsbarren 33 und 33' sowie den von diesen getragenen Zentriergliedern 31,31' vorwärts. Eine Zwischenstufe dieser Vorwärtsbewegung der Fluchtungs- und Zentrierteile ist in den Figuren 3 und 3A dargestellt.

In dieser Zwischenstellung haben die rückwärtigen Zentrierglieder 31 und 31' die rückwärtigen Eingriffsnocken 55 und 55' erfaßt, die an der unteren abgeschrägten Wandung der Nutmündungen 53 bzw. 53' aufwärts- und in die engen Zentriernuten 51 und 51' der Zentrierglieder 31 bzw. 31' hineingegleitten sind. Hierdurch werden die mittleren Bereiche der Gabelarme 41 bzw. 42 in eine Stellung parallel zur Plattenförderebene des Förderbandes 9 gebracht.

Auch sind hierdurch die freien Enden 47 und 48 der Gabelarme 41 und 42 genügend angehoben worden, so daß die Eingriffsnocken 56 und 56' in den vorderen Armbereichen sich nunmehr auf einem Niveau befinden, auf dem sie bei weiterer Vorwärtsbewegung der Fluchtungs- und Zentriereinrichtungen 29 und 30 von den Nutmündungen 54 bzw. 54' der vorderen Zentrierglieder 32 bzw. 32' erfaßt werden können. Dieses Erfassen hat jedoch bei der in Figuren 3 und 3A gezeigten Zwischenstellung noch nicht stattgefunden.

Es dürfte insbesondere aus Fig. 2A verständlich sein, daß, wenn nur ein einziger Eingriffsnok-

ken z.B. in einem mittleren Bereich vorwärts des Zentriergliedes 31 vorgesehen wäre, ein solcher Nocken die Nutmündung 53 des Zentriergliedes verfehlt haben könnte, indem er nämlich unterhalb dieser Mündung frontal gegen die untere Kante der Nutmündung am vorderen Ende 31a des Zentriergliedes 31 angeschlagen hätte.

Aber auch wenn das Zentrierglied 31 einen solchen Eingriffsnocken im Mittelbereich des Gabelarmes 41 erfaßt und den Gabelarm entsprechend angehoben hätte, würde dies bei stärker verbogenem Gabelarm, als dies in Fig. 2A gezeigt ist, nicht genügt haben, um das vordere Ende 47 des Gabelarmes 41, und natürlich entsprechend das vordere Ende 48 des Gabelarmes 42 hinreichend anzuheben, so daß die vorrückende Führungskante der zugeführten Platte P in die Gabelarmnuten 43 und 44 der beiden Gabelarme hätte eingeführt werden können. Statt dessen wäre die Platte P einfach aufwärts auf die Oberseiten der Gabelarme 41 und 42 geschoben worden.

Doch auch wenn die freien Gabelenden 47 und 48 durch solche versuchsweise angewandten Eingriffsnocken ausschließlich im Mittelbereich der Gabelarme 41 und 42 angehoben wären und die Führungskante und der an diese anschließende Bereich der Platte P in die vorderen offenen Enden der Gabelarmnuten 43 und 44 eingedrungen wäre, hätte das zusätzliche Gewicht der Platte P den ungestützten vorderen Bereich der Gabelarme 41 und 42 leicht abwärts biegen können und so die vorrückende Platte in den Gabelarmnuten verklemmt haben, indem der vorrückende Plattenbereich gegen die obere oder untere Nutenwandung klemmend angedrückt worden wäre und so die Beladungsphase verzögert oder unterbrochen hätte.

Dies wird nun bei den Fluchtungs- und Zentriereinrichtungen 29 und 30 völlig vermieden, sobald die Zentrierglieder 31,32 bzw. 31′,32′ durch die Antriebkolben 39,39′ in ihre vordere, in Figuren 4 und 4A gezeigte Endstellung vorgeschoben sind. In dieser Endstellung ist der vordere Nocken 56 auf der unteren Schrägwand der Nutmündung 54 aufwärts und in den engen Bereich der Nut 52 im vorderen Zentrierglied 32 hinein geglitten, das mit dem Gabelarm 41 zusammenwirkt, und das gleiche geschieht im Falle des Nockens 56′, der in den engen Bereich der Nut 52′ des mit dem anderen Gabelarm 42 zusammenwirkenden vorderen Zentriergliedes 32′ eingetreten ist.

Dies bedeutet, daß die vorderen offenen Enden der Gabelarmlängsnuten 43 und 44 nun genau in Bezug auf die Führungskante der Platte P zentriert sind, und während nun diese mit ihren rechten und linken unbeschichteten Randbereichen m in diese Nuten eingeschoben wird, werden die vorderen Bereiche der Gabelarme 41 und 42 hinreichend durch die vorderen auf ihren Lagern 38 und 38′ abgestützten Verbindungsstreben 35 und 35′ unterstützt, so daß das zusätzliche Gewicht der Platte P, während diese bis zur Endstellung zwischen den Gabelarmen 41 und 42 des Plattenträgers 14 eingeschoben wird, kein Verbiegen der Gabelarme verursachen kann. Daher können die Plattenträger und insbesondere die Gabelarme derselben aus wesentlich leichterem Material gebaut werden, was erhebliche Energie beim Betrieb der Anlage einsparen kann.

Während in allen Figuren 1 bis 4A die Zylinder 40 und 40′ seitlich neben den Zentriergliedern 31,31′,32,32′ und den Verbindungsbarren 33,33′ angebracht dargestellt sind, können sie natürlich auch zwecks besserer Stützung unter diesen angeordnet sein, natürlich ohne das Passieren der Plattenträger einschließlich der Nocken auf deren Gabelarmen zu stören (Fig. 7).

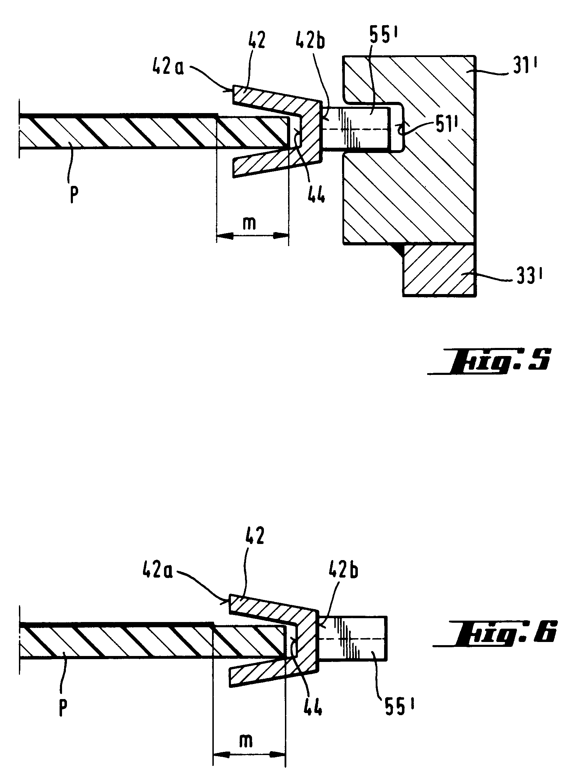

In den Figuren 5 und 7 sind die Zentrierglieder 31′ und 32′, ersteres im Schnitt und letzteres in Vorderansicht dargestellt. Aus Fig. 7 ist ersichtlich, daß der enge Bereich der Nut 52′ im vorderen Zentrierglied 32′ vorzugsweise in der oberen Hälfte des Gliedes angeordnet ist, wodurch das vordere Ende des letzteren oberhalb des engen Bereichs der Nut 54′ eine kleinere bzw. flachere Schrägfläche 54a′ und unterhalb der Nutmündung 54′ eine größere Schrägfläche 54b′. Dies erleichtert das Erfassen des Nockens 56′, der sich infolge des Abwärtsbiegens des vorderen Bereichs des Gabelarmess 42 auf einem niedrigeren Niveau befindet als die enge Nut 52′.

Die gleiche Ausgestaltung der engeren Nut 52 und der sich nach vorwärts erweiternden Nutmündung ist natürlich auch bei dem entsprechenden vorderen Zentrierglied 32 vorgesehen, das mit dem Nocken 56 auf dem Gabelarm 41 zusammenwirkt. Die gleiche Ausgestaltung kommt vorteilhaft auch bei den entsprechenden Durchlässen der rückwärtigen Zentrierglieder 31 und 31′ zur Anwendung.

In der vorstehend beschriebenen und in den Figuren 1 bis 7 dargestellten Ausführungsform der Fluchtungs- und Zentriereinrichtung nach der Erfindung wird das Einfluchten der Gabelarme eines Plattenträgers und das Zentrieren der freien Gabelarmenden in Bezug auf eine Plattenzufuhrebene, die sich horizontal erstreckt, beschrieben. Natürlich kann die gleiche Fluchtungs- und Zentriereinrichtung auch Gabelarmen zugeordnet werden, die auf eine schräge oder vertikale Plattenzufuhrebene ausgerichtet werden sollen, wobei allenfalls erforderliche bekannte Hilfsmittel zum Ausgleich eventuell auftretender Schwerkraftvektoren vorzusehen sind, die die für eine horizontale Anordnung ausgelegte Vorrichtung entsprechend ergänzen.

Die Fluchtungs- Und Zentriereinrichtung nach der Erfindung vermeidet in zufriedenstellender Weise die eingangs erläuterten Nachteile bekannter gabelförmiger Plattenträger, bei denen die Platten in Längsnuten der Gabelarme des Trägers eingeschoben werden müssen. So kann der Öffnungswinkel der sich nach außen erweiternden Nutmündung 53, 53′ des ersten, rückwärtigen Zentriergliedes unschwer weit genug gemacht werden, um die zugeordneten hinteren Gabelarmnocken 55,55′ noch zu erfassen, auch wenn die Abweichung des betreffenden Gabelarmes (41 oder 42) von der Horizontalebene beträchtlich ist. Die Einfluchtung, die diesem Gabelarm durch das erste, rückwärtige Zentrierglied erteilt wird, hebt den vorderen Bereich des Gabelarmes genügend an, um den vorderen Nocken 56,56′ soweit zu heben, daß er vom weiteren Öffnungsende der Nutmündung 54,54′ des vorderen Zentriergliedes 32,32′ noch mit Sicherheit erfaßt wird.

Sogar ein Plattenträger, dessen beide Gabelarme nicht nur in Bezug auf die Horizontalebene sondern einer gegenüber dem anderen stark verworfen sind, können ohne besondere Schwierigkeit durch die oben beschriebenen Einrichtungen 27 bis 30 nach der Erfindung ausgerichtet und zentriert werden, so daß ein glattes Beschicken und, falls erforderlich, ein ebenso glattes Entladen von Platten (in deren breitester Bedeutung) in die vorzugsweise mit Gabelarmnuten versehenen gabelförmigen Plattenträger des Transportmechanismus gewährleistet ist.

Natürlich muß die Fluchtungs- und Zentriereinrichtung nicht von rechts oder links an dem rechten bzw. linken Gabelarm angreifen, sondern kann dies auch ober- oder unterhalb der Gabelarme tun, wobei die Eingriffsnocken oder dergleichen Mittel auf der Oberseite oder der Unterseite der Gabelarme hervorstehen können, also auf einer der vom anderen Gabelarm wegweisenden Gabelarmaußenwände. Der intermittierende Transport darf dabei nicht behindert werden.

Während die in den Figuren 1 bis 7 dargestellten Fluchtungs- und Zentriereinrichtungen eine rückwärtige Einfluchtungseinheit und eine vordere Nachzentriereinheit zeigen, die Zentrierglieder umfassen, welche mit mechanischen Mitteln parallel in Bezug auf die Plattenzufuhrebene in bestimmten Abstand dazu gehalten werden, und Eingriffsnocken auf den Gabelarmen eines Plattenträgers zwecks Zusammenwirken mit den Zentriergliedern vorgesehen sind, können diese Anordnungen auch in anderer Weise ausgeführt werden. So können z.B. die Nocken auf den Gabelarmen eines Plattenträgers durch solche anderen Typs ersetzt werden, z.B. durch Zentrierglieder, deren Nuten dann auf einer vom Gabelarm abgewandten Seite offen sind, während die von aussen eingreifenden Mittel als Nocken ausgebildet sein müssen. Auch können die Zentrierglieder und Nocken durch andere, z.B.

elektromagnetische Mittel ersetzt werden, die jedoch die gleichen Funktionen ausüben wie die mechanischen. Entsprechend kann an Stelle einer gemeinsameen Verbindungsbarre eine Ausführungsform treten, in der das hintere und das vordere Zentrierglied getrennt von einander auf dem Anlagegestell verschiebbar angeordnet sind und in der gleichen Weise funktionieren wie in der beschriebenen Ausführungsform, indem elektromagnetische Antriebsmittel ihre Verschiebung zum Zusammenwirken mit entsprechenden Eingriffsmitteln auf den Gabelarmen veranlassen, wobei die Verschiebung im festgelegten Abstand und das Zusammenwirken elektronisch gesteuert werden können, statt daß dies pneumatisch oder hydraulisch geschieht.

Ein besonderer Vorteil der Fluchtungs- und Zentriermittel nach der Erfindung beruht auf der besonderen Unterstützung der vorderen Gabelarmenden während des Beschickens mit Platten, da hierdurch die Gabelarme aus wesentlich leichterem Material und weniger robust gebaut werden können, da die eingeschobene Platte die gesamte Trägerkonstruktion stabilisiert. Das leichtere Gewicht der Träger bedeutet eine merkbare Energieersparnis beim Betrieb der gesamten Anlage.

**Patentansprüche**

1. Transportvorrichtung für plattenförmige Elemente (P), insbesondere Leiteplatten, mit an einem Transportmechanismus (13) befestigten gabelförmigen Plattenträgern (14), welche von dem Transportmechanismus (13) in einem feststehenden Anlagegestell (25) intermittierend durch einen geradlinigen Bereich des Transportweges transportiert werden und dabei in einer Belade- bzw. Entladestation für die Platten (P) durch eine Zufuhr- oder Entnahmeebene bewegt werden, deren Gabelarme (41,42) an ihren hinteren Enden mit dem Transportmechanismus (13) verbunden sind und deren vordere freie Enden (47,48) vom Transportmechanismus (13) weggerichtet sind, wobei die von den Gabelarmen (41,42) jedes Plattenträgers (14) aufgespannte Ebene im allgemeinen nicht parallel zu der Zufuhr- oder Entnahmeebene verläuft, und mit einer Fluchtungs- und Zentriereinrichtung (29,30) zur Ausrichtung der Gabelarme (41,42) auf die Zufuhr- oder Entnahmeebene, dadurch gekennzeichnet, dass die Fluchtungs- und Zentriereinrichtung (29,30) Antriebsmittel (40,40') aufweist, die am Anlagegestell (25) stationär angebracht sind, sowie von diesen angetrieben und jedem der beiden Gabelarme (41,42) eines in der Belade- bzw. Entladestation befindlichen Plattenträgers (14) zugeordnet, eine erste hintere Vorzentriereinheit (31,51; 31',51') zum Einfluchten des rückwärtigen, sich zum hinteren Gabelende erstreckenden Gabelarmbereiches in die Zufuhr- oder Entnahmeebene und eine zweite, dem freien Gabelende (47,48) näher gelegene, vordere Nachzentriereinrichtung (32,56; 32',56'), zum Zentrieren der freien Gabelarmenden (47,48) und zum Ausrichten der vorderen Bereiche der Gabelarme (41,42) auf die Zufuhr- oder Entnahmeebene, umfasst.

2. Vorrichtung nach Anspruch 1, dadurch gekennzeichnet, daß die erste (31,55) und die zweite Zentriereinheit (32,56) jedes ein Zentrierglied (31,32) umfassen, die gemeinsam und in festem Abstand von einander durch die Antriebsmittel (40) zur Plattenzufuhrebene parallel hin- und her bewegbar sind, und daß die beiden Zentriereinheiten Eingriffselemente (55,56) umfassen, von denen jeder Gabelarm (41,42) auf seiner der zugeordneten Fluchtungs- und Zentriereinrichtung (29,30) zugewandten Seite (41b,42b) ein hinteres (55) und ein vorderes (56) Eingriffselement trägt, wobei das hintere zum Eingriff mit dem hinteren (31), und das vordere zum Eingriff mit dem vorderen (32) Zentrierglied dient, und wobei der Abstand ($d_2$) der den Zentriergliedern zugewandten Enden (55a,56a) der Eingriffelemente (55,56) von einander größer ist als der Abstand ($d_1$) der den letzteren zugewandten Enden (31a,32a) der Zentrierglieder (31,32), so daß beim Vorwärtsbewegen der letzteren zuerst das hintere Zentrierglied (31) mit dem hinteren Eingriffselement (55) und erst anschließend das vordere Zentrierglied (32) mit dem vorderen Eingriffsglied (56) in Eingriff kommt.

3. Vorrichtung nach Anspruch 2, dadurch gekennzeichnet, daß jedes Eingriffselement (55,56) einen aus der betreffenden Seite (41b,42b) des Gabelarmes herausragenden Zentriernocken darstellt und jedes Zentrierglied (31,32) in seiner dem zugeordneten Gabelarm (41,42) zugewandten, in Bezug auf die Plattenzufuhrebene senkrechten Seitenwand (31b,32b) eine zur Plattenzufuhrebene parallel verlaufende enge Längsnut (51,52) aufweist, die eine sich zum dem zugehörigen Nocken zugewandten Ende (31a,32a) des Zentriergliedes (31,32) hin erweiternde Nutmündung (53,54) von in der Ebene der Seitenwandung (31b,32b) vorzugsweise V-förmigen Ausschnitt vergrößert.

4. Vorrichtung nach Anspruch 3, dadurch gekennzeichnet, daß der enge Bereich der Längsnut (51) des hinteren Zentriergliedes (31) so lang ist, daß der hintere Zentriernocken (55) sich noch darin befindet, während der vordere Zentriernocken (56) in die Nutmündung (54) des vorderen Zentriergliedes (32) und bis in den anschließenden engen Nutbereich (52) hineingleitet.

5. Vorrichtung nach einem der Ansprüche 2 bis 4, dadurch gekennzeichnet, daß das Zentrierglied (31) der rückwärtigen Vorzentriereinheit (31,55) und das Zentrierglied (32) der vorderen Nachzentriereinheit (32,56) auf einem gemeinsamen Tragelement (33) im besagtem Abstand ihrer vorderen Stirnenden (31a,32a) voneinander befestigt sind und daß das Tragelement (33) mit dem Antriebsmittel (40,40') antreibbar verbunden ist.

6. Vorrichtung nach einem der Ansprüche 2 bis 5, dadurch gekennzeichnet, daß jeder der Gabelarme (41,42) auf seiner dem anderen Gabelarm zugekehrten Innenseite (41a,42a) eine Längsnut (43,44) aufweist, die am freien Gabelarmende (47,48) eine nach vorwärts gerichtete Nutenöffnung (43a,44a) zur Aufnahme der Ränder (m) einer entlang der Plattenzufuhrebene zugeführte Platte (P) aufweist und daß die vordere Nachzentriereinheit (32,56;32',56') dazu dient, diese Gabelarmnutenöffnung (43a,44a) auf die genannte Ebene zu zentrieren.

7. Vorrichtung nach einem der Ansprüche 2 bis 6, dadurch gekennzeichnet, daß der Abstand des rückwärtigen Endes des vom Gabelarm (41,42) getragenen hinteren Eingriffselementes (55,55') vom am Transportmechanismus (13) befestigten Ende des Gabelarmes (41,42) so groß ist, daß das hintere Zentrierglied (31,31') im Zwischenraum zwischen dem hinteren Eingriffselement (55,55') und dem Transportmechanismus (13) außen neben der das besagte Eingriffselement tragenden Seite (41b,42b) des Gabelarmes (41,42) bei Ausgangsstellung der besagten Einrichtung Platz findet.

8. Vorrichtung nach einem der Ansprüche 2 bis 7, dadurch gekennzeichnet, daß sie (29,30) mindestens ein Stützorgan (35,38;35',38') aufweist, welches so mit der vorderen Nachzentriereinheit (32,56;32',56') zusammenwirkt, daß diese das freie Ende (47,48) des Gabelarmes (41,42) beim Ausrichten und Zentrieren desselben gleichzeitig gegen zusätzliche Belastung durch eine zugeführte Platte (P) in Bezug auf das Anlagegestell (25) abstützt.

**Claims**

1. Transport device for board-shaped elements (P), especially circuit boards, comprising fork-shaped board carriers (14) which are fastened to a transport mechanism (13) and are transported by the transport mechanism (13) in a stationary frame (25) to move intermittently through a straight-line region of the transport path and, in so doing, are moved in a loading or unloading station for the boards (P) through a respective charging or removal plane, and the fork arms (41, 42) of which are connected at their rearward ends to the transport mechanism (13) and the forward, free ends (47, 48) of which point away from the transport mechanism (13), the plane spanned by the fork arms (41, 42) of each board carrier (14) generally not extending parallel to the charging or removal plane, and comprising an aligning and centering device (29, 30) for bringing the fork arms (41, 42) into register with the charging or removal plane, wherein the aligning and centering device (29, 30) has drive means (40, 40') which are mounted stationarily on the frame (25) and, driven thereby and associated with each of the two fork arms (41, 42) of a board carrier (14) located in the loading or unloading station, a first, rearward pre-centering unit (31, 51; 31', 51') for aligning the rearward fork arm region, extending towards the rearward fork end, with the charging or removal plane, and a second, forward post-centering device (32, 56; 32', 56'), arranged nearer the free fork end (47, 48), for centering the free fork arm ends (47, 48) and for aligning the forward regions of the fork arms (41, 42) with respect to the charging or removal plane.

2. Device according to claim 1, wherein the first centering unit (31, 55) and the second centering unit (32, 56) each comprise a centering member (31, 32), which centering members are reciprocally movable, by the drive means (40), together, at a fixed distance from each other and parallel to the board charging plane, and the two centering units comprise engaging elements (55, 56) of which each fork arm (41, 42) carries on its side (41b, 42b) facing the associated aligning and centering device (29, 30) a rearward (55) and a forward (56) engaging element, the rearward engaging element serving to engage the rearward centering member (31) and the forward engaging element serving to engage the forward centering element (32), and the distance ($d_2$) of the ends (55a, 56a), towards the centering members, of the engaging elements (55, 56) from each other being greater than the distance ($d_1$) of the ends (31a, 32a), towards the latter, of the centering members (31, 32), so that, as the latter move forward, first of all the rearward centering member (31) engages the rearward engaging element (55) and only subsequently does the forward centering member (32) engage the forward engaging element (56).

3. Device according to claim 2, wherein each engaging element (55, 56) is a centering projection protruding from the relevant side (41b, 42b) of the fork arm and each centering member (31, 32) has, in its side wall (31b 32b) perpendicular to the board charging plane and facing the associated fork arm (41, 42), a narrow longitudinal groove (51, 52) which extends parallel to the board charging plane and which enlarges a groove mouth (53, 54) of preferably V-shaped section in the plane of the side wall (31b 32b), which groove mouth widens towards the end (31a, 32a) of the centering member (31, 32) which is towards the associated projection.

4. Device according to claim 3, wherein the narrow region of the longitudinal groove (51) of the rearward centering member (31) is so long that the rearward centering projection (55) is still located therein while the forward centering projection (56) slides into the groove mouth (54) of the forward centering member (32) and into the adjoining narrow groove region (52).

5. Device according to any one of claims 2 to 4, wherein the centering member (31) of the rearward pre-centering unit (31, 55) and the centering member (32) of the forward post-centering unit (32, 56) are fastened to a common carrier element (33) at the said distance of their forward ends (31a, 32a) from each other, and the carrier element (33) is connected in a drivable manner to the drive means (40,' 40').

6. Device according to any one of claims 2 to 5, wherein each of the fork arms (41, 42) has on its inner side (41a 42a) facing the other fork arm a longitudinal groove (43, 44) which has at the free fork arm end (47, 48) a groove opening (43a, 44a) facing forwards for receiving the edges (m) of a board (P) advanced along the board charging plane, and the forward post-centering unit (32, 56; 32', 56') serves to centre that fork arm groove opening (43a 44a) with respect to the said plane.

7. Device according to any one of claims 2 to 6, wherein the distance of the rearward end of the rearward engaging element (55, 55') carried by the fork arm (41, 42) from the end of the fork arm (41, 42) which is fastened to the transport mechanism (13) is so great that there is room for the rearward centering member (31, 31') in the space between the rearward engaging element (55, 55') and the transport mechanism (13) on the outside, alongside the side (41b, 42b) of the fork arm (41, 42) carrying the said engaging element, in the starting position of the said device.

8. Device according to any one of claims 2 to 7, wherein it (29, 30) has at least one supporting element (35, 38; 35', 38') which co-operates with the forward post-centering unit (32, 56; 32', 56') in such a manner that the latter at the same time supports the free end (47, 48) of the fork arm (41, 42), during its alignment and centering, with respect to the frame (25) against additional loading by an advancing board (P).

## Revendications

1. Dispositif de transport destiné à des éléments (P) en forme de plaques, en particulier à des plaques de circuits imprimés, comportant des supports (14) de plaques en forme de fourche fixés à un mécanisme (13) de transport, qui sont transportés par le mécanisme (13) de transport dans un bâti (25) d'installation fixe, de manière intermittente, sur une partie rectiligne du trajet de transport, et qui y sont déplacés, dans un plan d'amenage ou de prélèvement, dans un poste de chargement ou de déchargement des plaques (P), supports dont les bras (41, 42) en forme de fourche sont reliés par leurs extrémités arrière au mécanisme (13) de transport et dont les extrémités avant (47, 48) libres sont dirigées à l'écart du mécanisme (13) de transport, le plan passant par les bras (41, 42) en forme de fourche de chaque support (14) de plaque ne s'étendant en général pas parallèlement au plan d'amenage et de prélèvement, et comportant un dispositif (29, 30) d'alignement et de centrage destiné à l'alignement des bras (41, 42) en forme de fourche avec le plan d'amenage et de prélèvement, caractérisé en ce que le dispositif d'alignement et de centrage (29, 30) présente des moyens (40, 40') d'entraînement qui sont montés de façon fixe sur le bâti (25) de l'installation, ainsi que, entraînés par ces moyens et associés à chacun des deux bras (41, 42), en forme de fourche, d'un support (14) de plaque qui se trouve dans le poste de chargement ou dans le poste de déchargement, une première unité arrière de précentrage (31, 51 ; 31', 51') destinée à aligner dans le plan d'amenage, ou dans le plan de prélèvement, la zone de bras en forme de fourche, qui s'étend en direction de l'extrémité arrière de la fourche, et une deuxième unité avant de centrage complémentaire (32, 56 ; 32', 56') située plus près de l'extrémité libre (47, 48) de la fourche, destinée au centrage des extrémités libres (47, 48) des bras en forme de fourche et à l'alignement des zones avant des bras (41, 42) en forme de fourche dans le plan d'amenage et de prélèvement.

2. Dispositif selon la revendication 1, caractérisé en ce que la première (31, 55) unité de centrage, et la seconde unité de centrage (32, 56) comprennent chacune un élément (31, 32) de centrage, lesquels éléments de centrage peuvent être déplacés ensemble en va-et-vient à l'aide des moyens d'entraînement 40 avec un écart fixe d'un élément par rapport à l'autre et parallèlement au plan d'amenage des plaques, et en ce que les deux unités de centrage comprennent des éléments (55, 56) de prise, chaque bras (41, 42) de fourche portant sur son côté (41b, 42b) orienté vers le dispositif d'alignement et de centrage (29, 30) un élément de prise arrière (55) et un élément de prise avant (56), l'élément de prise arrière servant à être mis en prise avec l'élément de centrage arrière (31) et l'élément de prise servant à être mis en prise avec l'élément de centrage avant (32), l'écart entre elles ($d_2$) des extrémités (55a, 56a) des éléments de prise orientées vers les éléments de centrage étant supérieur à l'écart ($d_2$) existant entre les extrémités (31a, 32a) des éléments de centrage (31, 32) orientés vers ceux-ci, si bien que lors du déplacement en avant de ces derniers, c'est d'abord l'élément de centrage arrière (31) qui est mis en prise avec l'élément de prise arrière (55) et que c est seulement ensuite que l'élément de centrage avant (32) est mis en prise avec l'élément de prise avant (56).

3. Dispositif selon la revendication 2, caractérisé en ce que chaque élément (55, 56) de prise présente un ergot de centrage qui fait saillie à partir du côté concerné (41b, 42b) du bras de fourche, et en ce que chaque élément (31, 32) de centrage présente dans sa paroi latérale (31b, 32b), orientée vers le bras de fourche correspondant (41, 42) une gorge longitudinale (51, 52) étroite, qui s'étend perpendiculairement au plan d'amenage des plaques, et qui s'agrandit pour former une embouchure (53, 54), dont la forme est de préférence celle d'un V dans le plan de la paroi latérale (31b, 32b), qui s'évase en direction de l'extrémité (31a, 32a) de l'élément de centrage (31, 32) orientée vers l'ergot correspondant.

4. Dispositif selon la revendication 3, caractérisé en ce que la zone étroite de la gorge longitudinale (51) de l'élément (31) de centrage arrière est assez longue pour que l'ergot (55) de centrage arrière s'y trouve encore pendant que l'ergot (56) de centrage avant pénètre en glissant dans l'embouchure (54) de la gorge de l'élément (32) de centrage avant, puis jusque dans la zone étroite (52) de la gorge qui lui fait suite.

5. Dispositif selon l'une des revendications 1 à 4, caractérisé en ce que l'élément (31) de centrage faisant partie de l'unité arrière de précentrage (31, 55) et l'élément (32) de centrage faisant partie de l'unité avant de centrage complémentaire (32, 56) sont fixés sur un élément (33) de support commun en présentant ledit écart de leurs extrémités frontales avant (31a, 32a) l'une par rapport à l'autre, et en ce que l'élément (33) de support est relié au moyen (40, 40') d'entraînement de façon à pouvoir être entraîné.

6. Dispositif selon l'une des revendications 2 à 5, caractérisé en ce que chacun des bras (41, 42) de fourche présente, sur son côté intérieur (41a, 42a) tourné vers l'autre bras de fourche, une gorge longitudinale (43, 44) qui comporte à l'extrémité libre (47, 48) du bras de fourche une ouverture (43a, 44a) de la gorge dirigée vers l'avant, destinée à recevoir les bords (m) d'une plaque (P) amenée dans le plan d'amenage des plaques, et en ce que l'unité avant de centrage complémentaire (32, 56 ; 32', 56') sert à centrer dans ledit plan cette ouverture (43a, 44a) de gorge de bras de fourche.

7. Dispositif selon l'une des revendications 2 à 6, caractérisé en ce que l'écart de l'extrémité arrière de l'élément (55, 55') de prise arrière porté par le bras (41, 42) de fourche, par rapport à l'extrémité du bras (41, 42) de fourche fixée au mécanisme (13) de transport est assez grand pour que l'élément (31, 31') de centrage arrière trouve place dans l'espace intermédiaire situé entre l'élément (55, 55') de prise arrière et le mécanisme (13) de transport, à l'extérieur, à proximité du côté (41b, 42b) du bras (41, 42) de fourche portant ledit élément de prise, lorsque ledit dispositif est en position de départ.

8. Dispositif selon l'une des revendications 2 à 7, caractérisé en ce que ce dispositif (29, 30) présente au moins un organe (35, 38 ; 35', 38') d'appui, qui coopère avec l'unité de centrage complémentaire avant (32, 56 ; 32', 56') de façon telle que celle-ci soutient, par rapport au bâti (25) de l'installation, l'extrémité libre (47, 48) du bras (41, 42) de fourche lors de l'alignement et du centrage de ce bras, et en même temps à l'encontre d'une charge supplémentaire due à l'amenage d'une plaque (P).

Fig. 1

Fig. 1A

13

EP 0 252 882 B1

**Fig. 2**

II A

Fig. 2A

Fig. 3

Fig. 3A

Fig. 4.

Fig. 4A

EP 0 252 882 B1

*Fig. 5*

*Fig. 6*

EP 0 252 882 B1

**Fig: 7**